# EUROPEAN PATENT SPECIFICATION

(11) **EP 2 465 137 B1**
(45) Date of publication and mention of the grant of the patent: **05.06.2013**
(21) Application number: 10745680.8
(22) Date of filing: 16.08.2010
(51) Int. Cl.: H01L 21/335, H01L 29/06, H01L 21/306, H01L 21/308, B82Y 10/00

(54) **METHOD FOR MANUFACTURING A SINGLE CRYSTAL NANO-WIRE.**
VERFAHREN ZUR HERSTELLUNG EINES EINKRISTALL-NANODRAHTS
PROCÉDÉ DE FABRICATION D'UN NANOFIL MONOCRISTALLIN

(30) Priority: 14.08.2009 NL 2003357
(43) Date of publication of application: 20.06.2012
(73) Proprietor: Universiteit Twente, 7522 NB Enschede (NL)
(72) Inventor: VAN DEN BERG, Albert, NL-7443 PC Nijverdal (NL); BOMER, Johan, NL-7482 AC Haaksbergen (NL); CARLEN, Edwin, Thomas, 7522 NB Enschede (NL); CHEN, Songyue, NL-5612 DV Eindhoven (NL); KRAAIJENHAGEN, Roderik, Adriaan, NL-1182 HE Amstelveen (NL); PINEDO, Herbert, Michael, NL-1075 HR Amsterdam (NL)
(74) Representative: Seitz, Holger Fritz Karl
(86) International application number: PCT/NL2010/050512
(87) International publication number: WO 2011/019282

(56) References cited:
- "Coulomb blockade oscillations at room temperature in a Si quantum wire metal-oxide-semiconductor field-effect transistor fabricated by anisotropic etching on a silicon-on-insulator substrate", APPLIED PHYSICS LETTERS, AIP, AMERICAN INSTITUTE OF PHYSICS, MELVILLE, NY, US LNKD- DOI:10.1063/1.116645, vol. 68, no. 25, 17 June 1996 (1996-06-17) , pages 3585-3587, XP012015525, ISSN: 0003-6951
- HASHIGUCHI G ET AL: "FABRICATION OF SILICON QUANTUM WIRES USING SEPARATION BY IMPLANTED OXYGEN WAFER", JAPANESE JOURNAL OF APPLIED PHYSICS, JAPAN SOCIETY OF APPLIED PHYSICS, JP LNKD- DOI:10.1143/JJAP.33.L1649, vol. 33, no. 12A, 1 December 1994 (1994-12-01), XP000682421, ISSN: 0021-4922 cited in the application
- HIRAMOTO T ED - INSTITUTE OF ELECTRICAL AND ELECTRONICS ENGINEERS: "Nano-scale silicon MOSFET: towards non-traditional and quantum devices", 2001 IEEE INTERNATIONAL SOI CONFERENCE PROCEEDINGS. DURANGO, CO, OCT. 1 - 4, 2001; [IEEE INTERNATIONAL SOI CONFERENCE], NEW YORK, NY : IEEE, US LNKD- DOI:10.1109/SOIC.2001.957959, 1 October 2001 (2001-10-01), pages 8-10, XP010563604, ISBN: 978-0-7803-6739-5

## Description

### Field of the invention

The invention relates to a method for manufacturing a single crystal nano-wire.

### Background of the invention

Over the past decade, there has been increasing interest in nano-scale devices due to their large surface to volume ratio and other unique properties. Fabrication of silicon nano-wire has been classified as either bottom-up or top-down. Silicon nano-wire devices made with bottom-up techniques are of high quality and high yield, but this technique lacks a suitable method to define wire positions and to form contacts in specific locations. It is difficult to form silicon nano-wires into functional device arrays. On the other hand, top-down silicon nano-wire fabrication uses standard techniques for semiconductor manufacturing. Nano-scale patterning is typically done with deep-UV lithography or e-beam lithography, followed by reactive ion etching or anisotropic wet etching to transfer nano-patterns on silicon-on-insulation (SOI) wafers. However, until recently, these techniques were not suitable for providing well defined planes of nano-wires.

A top-down silicon nano-wire fabrication process has been described by Hashigushi and Mimura ("Fabrication of Silicon Quantum Wires Using Separation by Implanted Oxygen Wager", Jap. J. Appl. Phys. Vol 33, 1994). In this document the combination of anisotropic etching and local oxidation of silicon techniques is proposed. The triangular cross-sectional dimensions of the silicon nano-wire are determined solely by the thickness of the used SOI layer. The document describes that a SOI layer may be provided with a thickness of 160 nm. After a 250 nm thick SiO2 layer was grown by thermal oxidation, a thinner SOI layer of about 50 nm was obtained by removing the oxide layer. Fabrication of silicon quantum wires with dimensions of 50 nm was reported.

However, the manufacturing of nano-wires with smaller dimensions are desired, since smaller nano-wires will have different properties. For example, it is known that silicon nano-wire sensitivity to surface potential increases greatly when their size is reduced from 200 nm to 50 nm and is expected to reduce even further when the dimensions of the nano-wire are reduced further.
"Coulomb blockade oscillations at room temperature in a Si quantum wire metal-oxide-semiconductor field-effect transistor fabricated by anisotropic etching on a silicon-on-insulator substrate" Applied physics letters, AIP, American institute of physics, Melville, NY, Vol. 68, nr. 25, June 17, 1996, pages 3585 - 3587 discloses a fabrication process of quantum wire MOSFET on a separation-by-implanted-oxygen substrate using anisotropic etching and selective oxidation.

### Summary of the invention

The objective of this invention is to provide an improved method enabling the manufacturing of a single crystal nano-structure. To achieve this objective a method for manufacturing a single crystal nano-structure is provided, comprising the following steps:
a) providing a device layer with a 100 structure on a substrate;
b) providing a stress layer onto the device layer;
c) patterning the stress layer along the 110 direction of the device layer;
d) selectively removing parts of the stress layer to obtain exposed parts of the device layer;
e) plane dependent etching of the exposed parts of the device layer to obtain an exposed 111 faces of the device layer;
f) thermally oxidizing the exposed 111 face of the device layer and forming a lateral oxidation layer at an interface of the device layer and the stress layer;
g) providing a mask layer onto the oxidized exposed 111 face of the device layer;
h) removing remaining parts of the stress layer to obtain further exposed parts of the device layer;
i) removing the mask layer;
j) plane dependent etching of the further exposed parts of the device layer to form a single crystal nano-structure with a triangular shaped cross section, until a side of the triangular shaped cross section being coplanar to a side of a cross section of the oxidized exposed 111 face is small in comparison with said side of the cross section of the oxidized exposed 111 face.

First a device layer with a 100 structure on a substrate is provided. In embodiments of the method according the invention this device layer may e.g. comprise a 100 p-type silicon wafer or a 100 n-type silicon wafer.

Then, a stress layer is provided onto the device layer. An advantage of the stress layer may be that it will prevent the formation of dislocations in the device layer due to stress. This stress is generated by the volume expansion of an oxide layer during thermal oxidation steps (see below). In case of a silicon device layer, the stress layer may comprise a silicon nitride layer. An advantage of the use of a silicon nitride layer is that the oxidation behaviour at the interface of the silicon device layer and the silicon nitride stress layer is well understood and reproducible.

Next, the stress layer is patterned along the 110 direction of the device layer and parts of the stress layer are selectively removed to obtain exposed parts of the device layer. The stress layer can also act as a mask during the subsequent step of plane dependent etching of the exposed parts of the device layer to obtain an exposed 111 face of the device layer.

Then, the exposed 111 face of the device layer is thermally oxidized and a lateral oxidation layer at an interface of the device layer and the stress layer is formed. An advantage of the oxidized exposed 111 face of the device layer and the lateral oxidation layer may be that they form a protection layer for the nano-structure during a following step of plane dependent etching.

After oxidation, a mask layer is provided onto the oxidized exposed 111 face of the device layer. Then, the remaining parts of the stress layer are removed to obtain further exposed parts of the device layer and the mask layer is removed.

In the next step, plane dependent etching of the further exposed parts of the device layer is carried out to form a single crystal nano-structure with a triangular shaped cross section. This process continues until a side of the triangular shaped cross section being coplanar to a side of a cross section of the oxidized exposed 111 face is small in comparison with said side of the cross section of the oxidized exposed 111 face.

An advantage of continuing the plane dependent etching may be that it enables a size reduction of the nanostructure. First a single crystal nano-structure with a triangular shaped cross section is formed with about the same dimensions as the oxidized exposed 111 face. When plane dependent etching is continued, the size of the single crystal nano-structure is further reduced in a recessed location between the oxidized exposed 111 face and a layer on which the device layer is provided. In an embodiment, the size can be reduced until the side of the triangular shaped cross section being up against a side of a cross section of the oxidized exposed 111 face is smaller than half the side of the cross section of the oxidized exposed 111 face.

An advantage of the method according to the invention may be that it enables fabrication of nano-structures with lateral dimensions down to 20 nm, The method can be applied using conventional micro-scale photolithography and fabrication processes.

Yet another advantage of the method according to the invention may be that it enables the implantation of dopants in a thicker region as well as doping the nano-structure, as is discussed below.

In another embodiment of the method according to the invention the thickness of the provided device layer is more than 50 nm, or is in the range 200-400 nm. This thickness of the provided device layer enables the removal of an initial ion-implantation region after ion-implementation. This initial ion-implantation region may have been damaged during the ion-implantation.

In yet another embodiment a thickness of the stress layer is less than 100 nm, or is in the range 80-40 nm, or is about 50 nm. An advantage of this thickness may be that it ensures that residual stress of the stress layer is low. Stress may be higher for thicker films. If the stress in the stress layer is too large, the device layer may be damaged, for example by induced dislocation in the crystal during oxidation steps.

In another embodiment, the silicon nitride layer stress layer may be deposited for example by low-pressure chemical vapor deposition or by plasma enhanced chemical vapor deposition.

In an embodiment of the method according to the invention, parts of the stress layer are selectively removed by reactive-ion etching.

In another embodiment, the plane dependent etching of the exposed parts of the device layer to obtain an exposed 111 faces of the device layer plane comprises comprises using a dilute tetramethyl ammonium hydroxide etching solution or a potassium hydroxide etching solution. An advantage of using a dilute tetramethyl ammonium hydroxide etching solution may be that is compatible with CMOS fabrication processes and that etching with this solution may be well controlled.

In another embodiment, the step of providing a mask layer onto the oxidized exposed 111 face of the device layer comprises depositing a polycrystalline silicon layer. An advantage of depositing a polycrystalline silicon layer may be that it effectively forms a mask without damaging the surface of the exposed 111 face of the device layer.

In another embodiment, the remaining parts of the stress layer are removed using a 60 degrees Celsius phosphoric acid etching solution.

According to an embodiment of the method according to the invention, the step of plane dependent etching of the further exposed parts of the device layer to form a single crystal nano-structure with a triangular shaped cross section, comprises using a dilute tetramethyl ammonium hydroxide etching solution or a potassium hydroxide etching solution. In an embodiment, the etching solution has a temperature of a 180 degrees Celsius.

An advantage of using these etching solutions may be that its working may be controlled precisely to enable controlling the reduction of the size of the nano-structure.

In a further embodiment, the method comprising the step of controlling the device layer conductivity. This may be achieved by implanting ions before a stress layer has been provided, thermal annealing during the fabrication process and removing an initial ion-implantation region during the step of plane dependent etching of the further exposed parts of the device layer, to form a single crystal nano-structure with a triangular shaped cross section.

An advantage of the thermal annealing may be that it enables the implanted ions to be electrically active by interstitial substitution in the silicon lattice. Another advantage may be that it enables redistribution of the implanted ions throughout the entire material, which yield a uniform distribution of implanted ions everywhere in the structure.

An advantage of the removal of an initial ion-implantation region may be that the device layer conductivity may be controlled without concern for damage to the nano-structure. After all, the region that may be damaged by the ion implementation is removed.

In another embodiment of the invention, the method comprises further the step of providing a gate dielectric. This step may comprise the steps of providing an oxide layer onto 111 surfaces with a thickness of 10-20 nm and thermal annealing in an N2 atmosphere. An advantage of these steps may be that the fixed charge is the oxide layer is minimized.

In yet another embodiment, the method further comprises the step of providing an electrical contact, This step may comprise the steps of selectively removing parts of the stress layer to form contact areas, providing a metal layer on the contact areas and thermal annealing. Advantageously, these steps will result in a good contact between the nano-structure and the metal layer, while the interface states are passivated. Furthermore, micro scale electrical contacts may be provided by conventional photolithography.

In another embodiment, the device layer may comprises a 100 p-type germanium wafer or a 100 n-type germanium wafer.

### Brief description of the drawings

Further advantageous embodiments of the method according to the invention are described in the claims and in the following description with reference to the drawing, in which:
Figure 1 shows three examples of atomic planes in a crystal lattice with its Miller indices;
Figures 2 depicts schematically a cross section of a device layer, in reference to which an embodiment of the method according to the invention is described;
Figure 3 depicts schematically a cross section of the device layer of figure 2 with a stress layer;
Figure 4 depicts schematically a cross section of the device layer of figure 3 with exposed 111 faces;
Figure 5 depicts schematically a cross section of the device layer of figure 4 with oxidized exposed 111 faces;
Figure 6 depicts schematically a cross section of a device layer of figure 5 with an enlarged portion of a lateral oxidation layer;
Figure 7 depicts schematically a cross section of a device layer of figure 6 after removal of parts of the stress layer;
Figure 8 depicts schematically a cross section of a device layer during step of plane dependent etching;
Figure 9 depicts schematically a size reduction of a cross section of a nano-structure and an enlargement of a protective lateral oxidation layer;
Figure 10 depicts schematically a cross section of a nano-structures with rounded tips, in reference to which an embodiment of the method according to the invention is described;
Figure 11 depicts schematically a top view of a nano-structure, in reference to which an embodiment of the method according to the invention is described;
Figure 12 depicts schematically a cross section of a nano-structure, in reference to which an embodiment of the method according to the invention is described;
Figure 13 depicts schematically a cross section of figure 12 with electrical contacts, in reference to which an embodiment of the method according to the invention is described.

### Detailed description of the invention

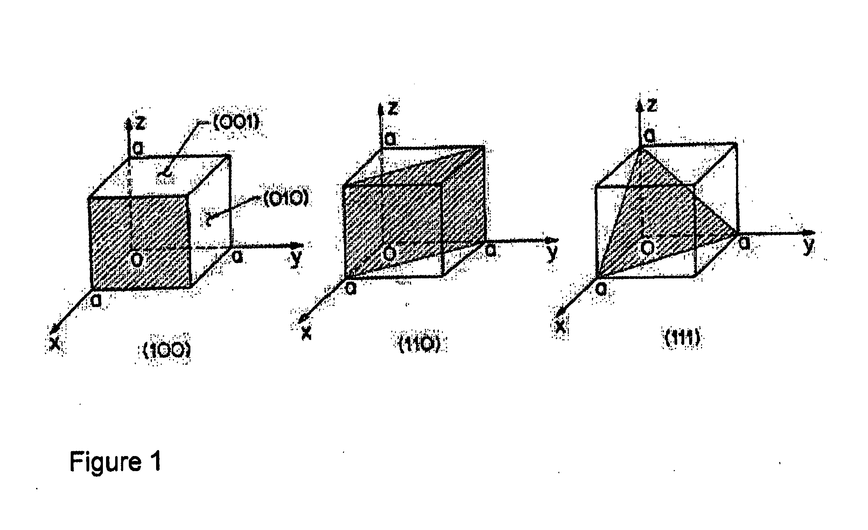

In the following, the term 100 (and other terms with three numbers) refers to three Miller indices in a row, which together form a symbolic vector representation for the orientation of an atomic plane in a crystal lattice. In figure 1, atomic planes of with a 100, a 110 and a 111 Miller reference are depicted. Thus, throughout this document the following applies: the term "a 100 structure" may refer to a crystal lattice structure with an atomic plane with a 100 orientation. It may also be referred to as a 100 crystal lattice structure. The term "a 110 direction" may refer to a direction of a 110 orientation of an atomic plane in a crystal lattice. The term "a 111 face" may refer to a face with a 111 orientation of an atomic plane in a crystal lattice.

An element of the invention is the use of plane dependent etching (PDE). An electrochemical model has been proposed to explain the plane dependent etching behaviour due to small differences in the energy levels of the back-bond surface states as functions of crystal orientation. This model indicates, for example, that two silicon back-bonds must be broken to etch the 100 and 110 surfaces and three for the 111 surface. From the model, it also follows that R(110) <R(100) <R(111), with R being the etch rate of the particular surface. This relationship has been found in measured etch rates for alkaline etching solutions. Typical PDE etch ratios for potassium hydroxide (KOH) at room temperature are R(110) /R(111 ) ~ 160 and R(100) /R(111) ~100, and for tetra methyl ammonium hydroxide (TMAH) at 60°C are R(110) /R(111) ~ 40 and R(100) /R(111) -20 common.

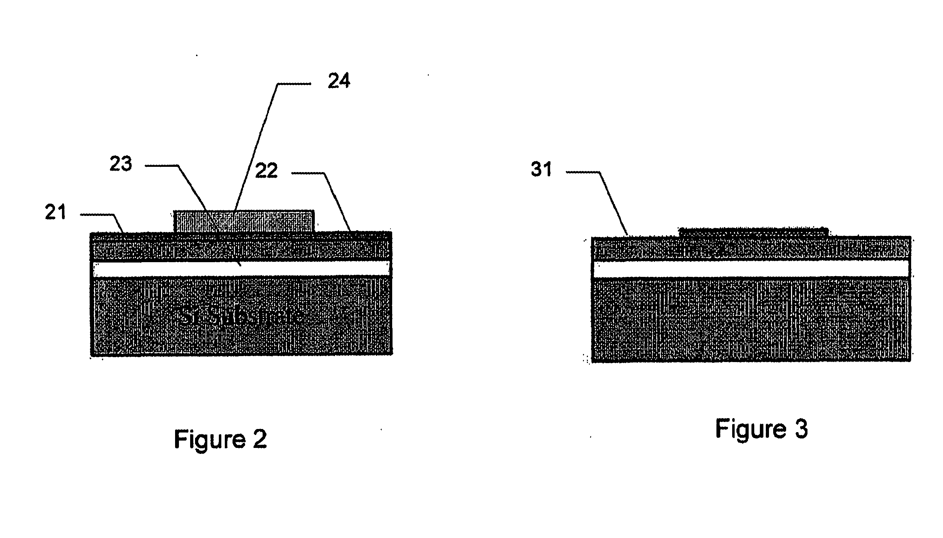

Figure 2 depicts a device layer 21 on an isolator 23 according to the invention. This can be a p-type 100 SOI (silicon on isolator) wafer, for example a silicon implanted with oxygen, as is made by SIMOX, Ibis, Inc., U.S.A. or a so-called UNIBOND made by SOITEC, Bernin, France. In figure 2, a stress silicon nitride (SiN) layer 22 has been deposited onto the silicon device layer. This can be done by low-pressure chemical vapor deposition (LPCVD). A thin (<100 nm) low-stress silicon nitride layer is required to prevent the formation of dislocations in the silicon layer due to stress generated by the volume expansion of the silicon dioxide layer during following thermal oxidation steps. The silicon nitride layer is lithographically aligned to the 110 crystal direction of the wafer, patterned with mask 24 and selectively removed with reactive-ion etching (RIE). The result is shown in figure 3, where the exposed parts of the device layer are indicated by 31. Lithography alignment errors may be less than 1 degree. The 110 crystalline planes may be aligned with the wafer flat within ±0.5 degrees as specified in the ASTM wafer standards.

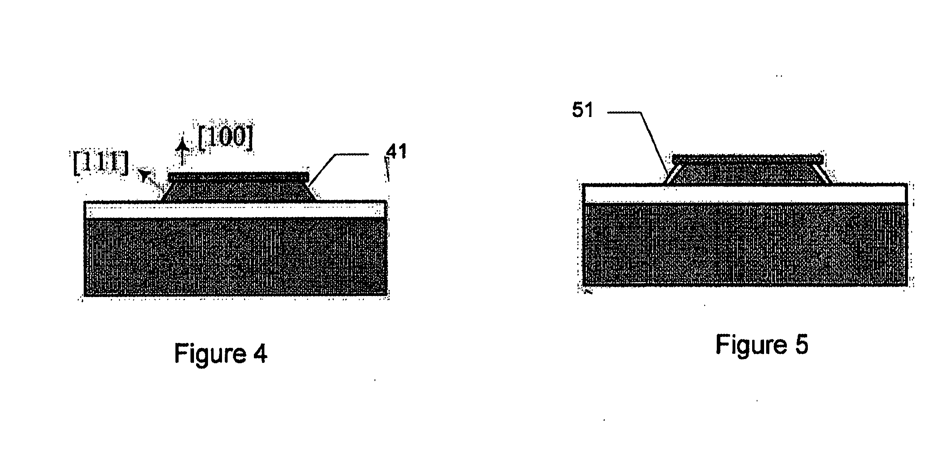

The exposed parts of the device layer are then etched, for example in a dilute tetramethyl ammonium hydroxide (5% TMAH, C4H13NO) etching solution. The 100 planes etch far more faster than the 111 planes, which results in a trapezoidal silicon region with sidewall angles of 54.74 degrees, precisely determined by the crystal structure of the silicon lattice, as can been in figure 4. An exposed 111 face of the device layer is indicated by 41.

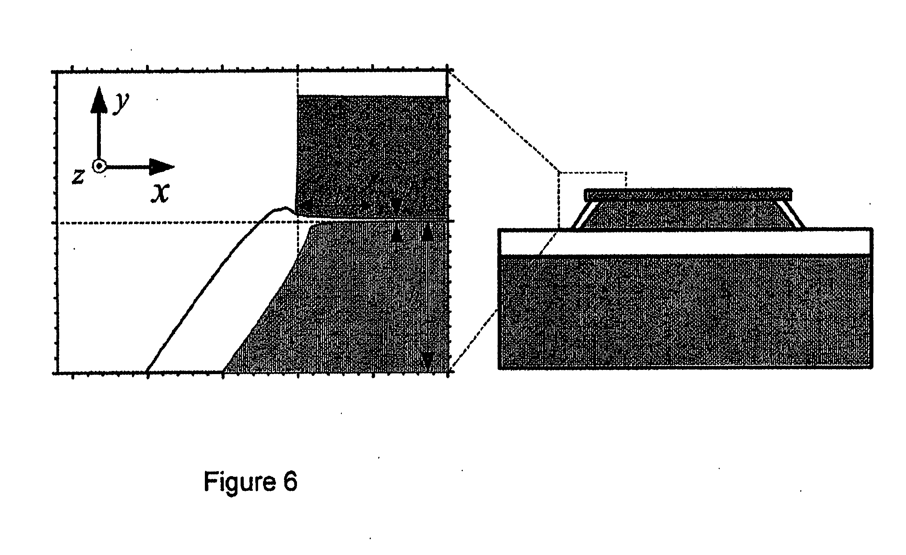

In the next step, the exposed 111 faces of the device layer are thermally oxidized, for example in a dry environment of 950 degrees Celsius for 15 min. This results in a oxidized exposed 111 face of the device layer 51 as can be seen in figure 5. Also a lateral oxidation layer at an interface of the device layer and the stress layer is formed. In figure 6 the lateral oxidation layer has been depicted enlarged. The lateral oxidation in the x-direction provides a uniform oxide layer along the z-direction on the silicon surface, with a buffer oxide thickness d between the silicon and the stress layer. The length I of the lateral oxidation layer is controlled by a starting oxide thickness d between the silicon and the stress layer, an oxidation time and an oxidation temperature. The layer may have a length up to 50 nm, but a larger lateral oxidation layer may inhibit the following PDE step.

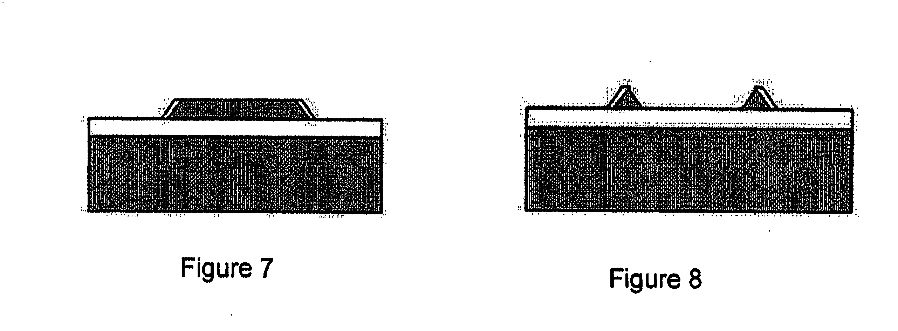

In a next step, the stress layer is selectively removed. First a patterned 50-nm-thick polycrystalline silicon (polysilicon) etch mask is provided by using, for example, low-pressure chemical vapor deposition. An advantage of the polysilicon layer may be that it covers all surfaces at the interface of the device layer and the stress layer and it has relatively high etch selectivity compared to the stress layer. When stress layer is etched by using a hot phosphoric acid (85% H3PO4) at 180 degrees Celsius, the patterned stress layer is removed with minimal damage to the exposed 111 silicon surfaces. The result of this step is depicted in figure 7.

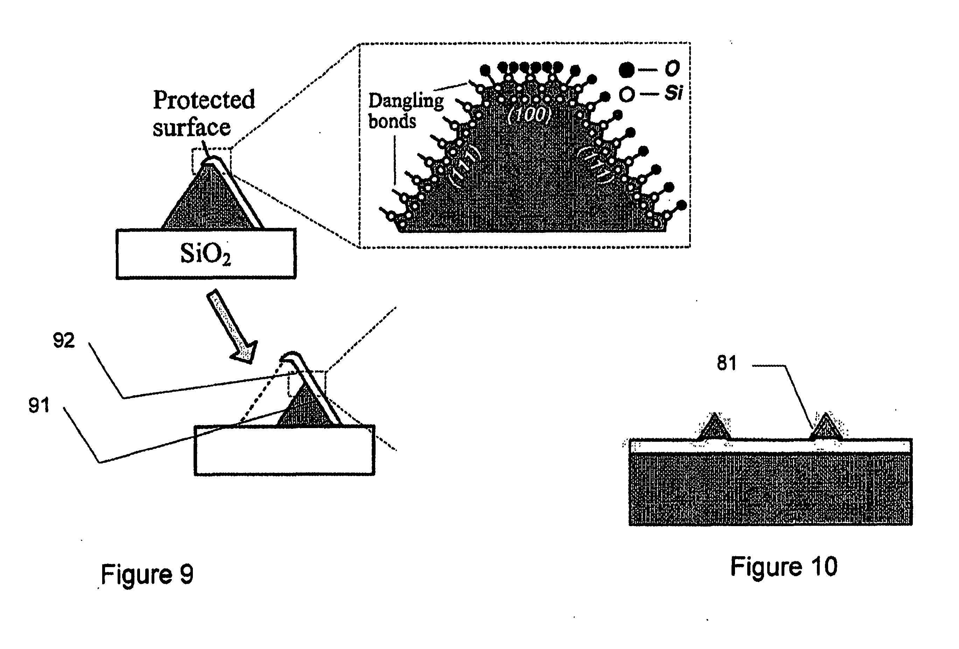

During a second plane dependent etching step with for example a dilute tetramethyl ammonium hydroxide (5% TMAH, C4H13NO) etching solution at 60 degrees Celsius, a single crystal nano-structure with a triangular shaped cross section is formed, which is depicted in figure 8. The oxidized exposed 111 face on one side of the structure acts as an etch mask. When the plane dependent etching continues, the size of the single crystal nano-structure will be reduced while the cross section stays triangular shaped. This process can be seen in figure 9. The lateral oxidation layer prevents etching of the 100 planes because all dangling silicon bonds have been terminated with oxygen from the thermal oxidation step. As can be seen, side 91 of the triangular shaped cross section is coplanar to cross section 92 of the oxidized exposed 111 face. After the second plane dependent etching step, side 91 is small in comparison with side 92. The single crystal nano-structure is recessed in the oxidized exposed 111 face.

The size reduction etch rate can be changed by reducing the process temperature. With a lower temperature and therefore lower etch rate, control of the final device dimensions can be improved.

An advantage of this method for manufacturing a single crystal nano-structure may be that in the same single crystal device layer, electrical contact regions may be formed on a thick device layer part (-200 nm), while the size of the single crystal nano-structure is reduced to the desired dimensions in the thin silicon layer (-20 nm). The top-down fabrication of single crystal nano-structures commonly known in the art begins by thinning the SOI device layer to the desired thickness of the final device. Therefore, the single crystal nano-structure and the electrical contact regions have the same small thickness, which can lead to high contact resistances.

The device layer conductivity can be controlled by implanting ions and thermal annealing. For example, atoms (e.g. B, P, As) can be implanted in the silicon layer, before a stress layer has been provided. Thermal annealing takes place during the whole fabrication process. For controlling the device layer conductivity, a so-called "thermal budget" can be calculated during each step of the process. The process may for example be modelled in a commercial software package (for example Suprem) that allows prediction of the final dopant profiles at the end of the fabrication process. Another way of controlling the device layer conductivity, is the use of spin-on dopants.

Another advantage of the method according to the invention is the removal of the initial ion-implantation region. For example, an initial silicon device layer with a thickness of 200 nm is implanted with BF2+ ions at an average energy of 20 keV and a wafer angle of 7°. In that case any crystal damage caused by the implantation is contained primarily in the first 100 nm of the silicon device layer. Subsequent thermal annealing results in the redistribution of the dopants and electrical activation throughout the entire thickness of the silicon device layer. The initial ion-implantation region is then removed during the etching steps from the resulting single crystal nano-structure.

For applications requiring a gate dielectric, a thin oxide layer (10-20 nm) may be grown on an exposed 111 surface of the singe crystal nano-structure, that is indicated by 81 in figure 10. After growing the thin oxide layer, the tip of the single crystal nano-structure is rounded as can be seen in figure 10. The wafer may then be annealed in an N2 atmosphere (900 degrees Celsius for 30 min) in order to form a uniform doping concentration, to electrically activate the dopants and to minimize the fixed charge in the oxide layer.

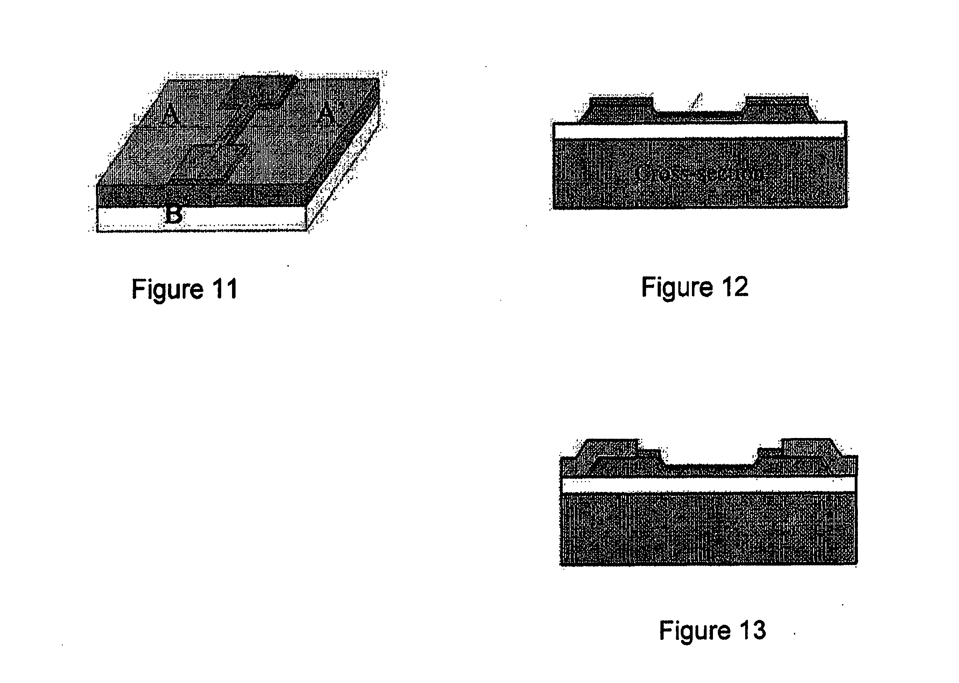

Figure 11 depicts a top view of the single crystal nano-structure. Previous figures have depicted cross-sections at the A-A' -line, while figure 12 and 13 show a cross section at the B-B' - line.

In another embodiment of the method according to the invention, electrical contacts are provided. First, parts of the stress layer are removed using reactive ion etching. It may be advantageous to provided the electrical contacts on parts of the single crystal nano-structure which have not been etched by the plane dependent etching process. The fact that those parts are thicker than the parts which have been etched by the plane dependent etching process, may provide several advantages. The electrical contacts may have a low-resistance contact with the nano-structure. Furthermore, the electrical contacts may have micro scale dimensions and may therefore be form with conventional photolithography.

Also, a part of the isolator (i.e. the buried oxide layer) in the substrate is exposed using a buffered hydrofluoric acid wet etch. Then a 400-nm layer of a metal, for example AI, is deposited on the contact area formed by the exposed parts of the single crystal nano-structure and the exposed parts of the buried oxide layer. In order to form a good contact between the nano-structure and the metal layers and to passivate the interface states, the wafer is annealed in a N2 atmosphere with 5% H2, during 10 minutes at 400 degrees Celsius.

As required, detailed embodiments of the present invention are disclosed herein; however, it is to be understood that the disclosed embodiments are merely exemplary of the invention, which can be embodied in various forms. Therefore, specific structural and functional details disclosed herein are not to be interpreted as limiting, but merely as a basis for the claims and as a representative basis for teaching one skilled in the art to variously employ the present invention in virtually any appropriately detailed structure. Further, the terms and phrases used herein are not intended to be limiting, but rather, to provide an understandable description of the invention. The mere fact that certain measures are recited in mutually different dependent claims does not indicate that a combination of these measures cannot be used to advantage.

## Claims

1. Method for manufacturing a single crystal nano-structure comprising the steps of:
a) providing a device layer (21) with a 100 orientation on a substrate;
b) providing a stress layer (22) onto the device layer;
c) patterning (24) the stress layer along the 110 direction of the device layer;
d) selectively removing parts of the stress layer (22) to obtain exposed parts (31) of the device layer;
e) plane dependent etching of the exposed parts (31) of the device layer to obtain an exposed 111 faces of the device layer (41);
f) thermally oxidizing the exposed 111 face of the device layer (41) and forming a lateral oxidation layer at an interface of the device layer and the stress layer;
g) providing a mask layer onto the oxidized exposed 111 face of the device layer (51);
h) removing remaining parts of the stress layer (22) to obtain further exposed parts of the device layer;
i) removing the mask layer;
j) plane dependent etching of the further exposed parts of the device layer to form a single crystal nano-structure with a triangular shaped cross section, until a side (91) of the triangular shaped cross section being coplanar to a cross section of the oxidized exposed 111 face is small in comparison with said side (92) of the cross section of the oxidized exposed 111 face.

2. Method according to claim 1 wherein the side of the triangular shaped cross section being up against a side of a cross section of the oxidized exposed 111 face is smaller than half the side of the cross section of the oxidized exposed 111 face.

3. Method according to one of claims 1-2 wherein the device layer (21) comprises a 100 p-type silicon wafer or a 100 n-type silicon wafer.

4. Method according to one of claims 1-3, wherein a thickness of the provided device layer is more than 50 nm, or is in the range 200-400 nm.

5. Method according to one of claims 3-4, wherein the stress layer (22) comprises a silicon nitride layer.

6. Method according to one of claims 3-5, wherein a thickness of the stress layer (22) is less than 150 nm, or is in the range 100-40 nm, or is about 50 nm.

7. Method according to one of claims 5-6, wherein step b) comprises depositing the silicon nitride layer by low-pressure chemical vapor deposition or by plasma enhanced chemical vapor deposition.

8. Method according to one of claims 1-7, wherein step d) comprises selectively removing parts of the stress layer (22) by reactive-ion etching.

9. Method according to one of claims 3-8, wherein step e) comprises using a dilute tetramethyl ammonium hydroxide etching solution or a potassium hydroxide etching solution.

10. Method according to one of claims 3-9, wherein step g) comprises depositing a polycrystalline silicon layer.

11. Method according to one of claims 3-10, wherein step h) comprises using a 60 degrees Celsius phosphoric acid etching solution.

12. Method according to one of claims 3-11, wherein step j) comprises using a dilute tetramethyl ammonium hydroxide etching solution or a potassium hydroxide etching solution.

13. Method according to one of claims 12-13, wherein the etching solution has a temperature of a 180 degrees Celsius.

14. Method according to one of claims 1-14 further comprising the step of
I) controlling a device layer conductivity, comprising the steps of
1) implanting ions before step b)
2) thermal annealing during steps b)-k)
3) removing an initial ion-implantation region during step k)

15. Method according to one of claims 1-15 further comprising the step of m) providing a gate dielectric, comprising the steps of
1) providing an oxide layer onto 111 surfaces with a thickness of 10-20 nm
2) thermal annealing in an N2 atmosphere.

16. Method according to one of claims 1-16 further comprising the step of n) providing an electrical contact comprising the steps of
1) selectively removing parts of the stress layer to form contact areas
2) providing a metal layer on the contact areas
3) thermal annealing

17. Method according to claim 16, wherein the contact areas are formed on parts of the device layer, cross-sectional dimensions thereof being larger than the triangular shaped cross section.

18. Method according to claim 1, wherein the device layer comprises a 100 p-type germanium wafer or a 100 n-type germanium wafer.

## Patentansprüche

1. Verfahren zum Herstellen einer Einkristall-Nanostruktur, die Schritte umfassend:
a) Bereitstellen einer Vorrichtungsschicht (21) mit einer 100-Orientierung auf einem Substrat;
b) Bereitstellen einer Verspannungsschicht (22) auf der Vorrichtungsschicht;
c) Strukturieren (24) der Verspannungsschicht entlang der 110-Richtung der Vorrichtungsschicht;
d) selektives Entfernen von Teilen der Verspannungsschicht (22), um freigesetzte Teile (31) der Vorrichtungsschicht zu erhalten;
e) ebenenabhängiges Ätzen der freigesetzten Teile (31) der Vorrichtungsschicht, um freigesetzte 111-Flächen der Vorrichtungsschicht (41) zu erhalten;
f) thermisches Oxidieren der freigesetzten 111-Fläche der Vorrichtungsschicht (41) und Ausbilden einer lateralen Oxidationsschicht an einer Schnittstelle der Vorrichtungsschicht und der Verspannungsschicht;
g) Bereitstellen einer Maskenschicht auf der oxidierten freigesetzten 111-Fläche der Vorrichtungsschicht (51);
h) Entfernen übrig gebliebener Teile der Verspannungsschicht (22), um weitere freigesetzte Teile der Vorrichtungsschicht zu erhalten;
i) Entfernen der Maskenschicht;
j) ebenenabhängiges Ätzen der weiteren freigesetzten Teile der Vorrichtungsschicht, um eine Einkristall-Nanostruktur mit einem dreiecksförmigen Querschnitt auszubilden, bis eine Seite (91) des dreiecksförmigen Querschnitts, die koplanar mit einem Querschnitt der oxidierten freigesetzten 111-Fläche ist, klein im Vergleich mit der Seite (92) des Querschnitts der oxidierten freigesetzten 111-Fläche ist.

2. Verfahren gemäß Anspruch 1, wobei die Seite des dreiecksförmigen Querschnitts, die an eine Seite eines Querschnitts der oxidierten freigesetzten 111-Fläche anliegt, kleiner ist als die Hälfte der Seite des Querschnitts der oxidierten freigesetzten 111-Fläche.

3. Verfahren gemäß einem der Ansprüche 1-2, wobei die Vorrichtungsschicht (21) einen 100 p-Typ Siliziumwafer oder einen 100 n-Typ Siliziumwafer umfasst.

4. Verfahren gemäß einem der Ansprüche 1-3, wobei eine Dicke der bereitgestellten Vorrichtungsschicht mehr als 50 nm beträgt oder in dem Bereich von 200-400 nm liegt.

5. Verfahren gemäß einem der Ansprüche 3-4, wobei die Verspannungsschicht (22) eine Silizium-Nitrid-Schicht umfasst.

6. Verfahren gemäß einem der Ansprüche 3-5, wobei eine Dicke der Verspannungsschicht (22) kleiner als 150 nm ist oder in dem Bereich von 100-40 nm liegt oder ungefähr 50 nm beträgt.

7. Verfahren gemäß einem der Ansprüche 5-6, wobei Schritt b) Ablagern der Silizium-Nitrid-Schicht mittels niederdruckchemischer Beschichtung oder durch plasmaverstärkte chemische Beschichtung umfasst.

8. Verfahren gemäß einem der Ansprüche 1-7, wobei Schritt d) selektives Entfernen von Teilen der Verspannungsschicht (22) mittels Reaktivem-Ionen-Ätzen umfasst.

9. Verfahren gemäß einem der Ansprüche 3-8, wobei Schritt e) Verwenden einer verdünnten Tetramethyl-Ammonium-Hydroxid-Ätzlösung oder einer Kalium-Hydroxid-Ätzlösung umfasst.

10. Verfahren gemäß einem der Ansprüche 3-9, wobei Schritt g) Ablagern einer polykristallinen Siliziumschicht umfasst.

11. Verfahren gemäß einem der Ansprüche 3-10, wobei Schritt h) Verwenden einer Phosphorsäure-Ätzlösung bei 60°C umfasst.

12. Verfahren gemäß einem der Ansprüche 3-11, wobei Schritt j) Verwenden einer verdünnten Tetramethyl-AmmoniumHydroxid-Ätzlösung oder einer Kalium-Hydroxid-Ätzlösung umfasst.

13. Verfahren gemäß einem der Ansprüche 12-13, wobei die Ätzlösung eine Temperatur von 180°C hat.

14. Verfahren gemäß einem der Ansprüche 1-14, weiterhin den Schritt umfassend:
1) Steuern einer Vorrichtungsschicht-Leitfähigkeit, die Schritte umfassend:
1) Implantieren von Ionen vor Schritt b)
2) thermisches Ausheilen während Schritten b)-k)
3) Entfernen einer initialen Ionen-Implantations-Region während Schritt k).

15. Verfahren gemäß einem der Ansprüche 1-15, weiterhin den Schritt umfassend:
m) Bereitstellen eines Gate-Dielektrikums, die Schritte umfassend:
1) Bereitstellen einer Oxidschicht mit einer Dicke von 10-20 nm auf 111-Flächen
2) thermisches Ausheilen in einer N2-Atmosphäre.

16. Verfahren gemäß einem der Ansprüche 1-16, weiterhin den Schritt umfassend:
n) Bereitstellen eines elektrischen Kontaktes, die Schritte umfassend:
1) selektives Entfernen von Teilen der Verspannungsschicht, um Kontaktgebiete auszubilden
2) Bereitstellen einer Metallschicht auf den Kontaktgebieten
3) thermisches Ausheilen.

17. Verfahren gemäß Anspruch 16, wobei die Kontaktgebiete auf Teilen der Vorrichtungsschicht ausgebildet sind, wobei Querschnittsabmessungen von diesen größer als der dreiecksförmige Querschnitt sind.

18. Verfahren gemäß Anspruch 1, wobei die Vorrichtungsschicht einen 100 p-Typ Germaniumwafer oder einen 100 n-Typ Germaniumwafer umfasst.

## Revendications

1. Procédé pour fabriquer une nanostructure monocristalline comprenant les étapes consistant à :
a) disposer une couche de dispositif (21) avec une orientation 100 sur un substrat ;
b) disposer une couche de contrainte (22) sur la couche de dispositif ;
c) modeler (24) la couche de contrainte le long de la direction 110 de la couche de dispositif ;
d) enlever sélectivement des parties de la couche de contrainte (22) pour obtenir des parties exposées (31) de la couche de dispositif ;
e) attaquer de façon dépendante du plan les parties exposées (31) de la couche de dispositif pour obtenir des faces 111 exposées de la couche de dispositif (41) ;
f) oxyder thermiquement la face 111 exposée de la couche de dispositif (41) et former une couche d'oxydation latérale à une interface de la couche de dispositif et la couche de contrainte ;
g) disposer une couche de masque sur la face 111 exposée oxydée de la couche de dispositif (51) ;
h) enlever les parties restantes de la couche de contrainte (22) pour obtenir des parties exposées supplémentaires de la couche de dispositif ;
i) enlever la couche de masque ;
j) attaquer de façon dépendante du plan les parties exposées supplémentaires de la couche de dispositif pour former une nanostructure monocristalline avec une section transversale de forme triangulaire, jusqu'à ce qu'un côté (91) de la section transversale de forme triangulaire étant coplanaire avec une section transversale de la face 111 exposée oxydée soit petit par comparaison audit côté (92) de la section transversale de la face 111 exposée oxydée.

2. Procédé selon la revendication 1 dans lequel le côté de la section transversale de forme triangulaire étant contre un côté d'un section transversale de la face 111 exposée oxydée est plus petit que la moitié du côté de la section transversale de la face 111 exposée oxydée.

3. Procédé selon une des revendications 1 à 2 dans lequel la couche de dispositif (21) comprend une tranche de silicium de type p 100 ou une tranche de silicium de type n 100.

4. Procédé selon une des revendications 1 à 3, dans lequel l'épaisseur de la couche de dispositif produite est supérieure à 50 nm, ou est dans la plage de 200 à 400 nm.

5. Procédé selon une des revendications 3 à 4, dans lequel la couche de contrainte (22) comprend une couche de nitrure de silicium.

6. Procédé selon une des revendications 3 à 5, dans lequel l'épaisseur de la couche de contrainte (22) est inférieure à 150 nm, ou est dans la plage de 100 à 40 nm, ou est d'environ 50 nm.

7. Procédé selon une des revendications 5 à 6, dans lequel l'étape b) comprend le dépôt de la couche de nitrure de silicium par dépôt chimique en phase vapeur à basse pression ou par dépôt chimique en phase vapeur activé par plasma.

8. Procédé selon une des revendications 1 à 7, dans lequel l'étape d) comprend le retrait sélectif de parties de la couche de contrainte (22) par attaque par ions réactifs.

9. Procédé selon une des revendications 3 à 8, dans lequel l'étape e) comprend l'utilisation d'une solution d'attaque d'hydroxyde de tétraméthylammonium diluée ou une solution d'attaque d'hydroxyde de potassium.

10. Procédé selon une des revendications 3 à 9, dans lequel l'étape g) comprend le dépôt d'une couche de silicium polycristallin.

11. Procédé selon une des revendications 3 à 10, dans lequel l'étape h) comprend l'utilisation d'une solution d'attaque d'acide phosphorique à 60 degrés Celsius.

12. Procédé selon une des revendications 3 à 11, dans lequel l'étape j) comprend l'utilisation d'une solution d'attaque d'hydroxyde de tétraméthylammonium diluée ou une solution d'attaque d'hydroxyde de potassium.

13. Procédé selon une des revendications 12 à 13, dans lequel la solution d'attaque a une température de 180 degrés Celsius.

14. Procédé selon une des revendications 1 à 14 comprenant en outre l'étape consistant à
1) réguler la conductivité d'une couche de dispositif, comprenant les étapes consistant à
1) implanter des ions avant l'étape b)
2) effectuer un recuit thermique pendant les étapes b) à k)
3) enlever une région d'implantation d'ions initiale pendant l'étape k).

15. Procédé selon une des revendications 1 à 15 comprenant en outre l'étape consistant à
m) disposer un diélectrique de grille, comprenant les étapes consistant à
1) disposer une couche d'oxyde sur les surfaces 111 ayant une épaisseur de 10 à 20 nm
2) effectuer un recuit thermique dans une atmosphère de N₂.

16. Procédé selon une des revendications 1 à 16 comprenant en outre l'étape consistant à
n) produire un contact électrique comprenant les étapes consistant à
1) enlever sélectivement des parties de la couche de contrainte pour former des zones de contact
2) disposer une couche de métal sur les zones de contact
3) effectuer un recuit thermique.

17. Procédé selon la revendication 16, dans lequel les zones de contact sont formées sur des parties de la couche de dispositif, les dimensions de section transversale de celles-ci étant plus grandes que la section transversale de forme triangulaire.

18. Procédé selon la revendication 1, dans lequel la couche de dispositif comprend une tranche de germanium de type p 100 ou une tranche de germanium de type n 100.
